# EUROPÄISCHE PATENTANMELDUNG

(11) **EP 4 593 289 A1**
(43) Veröffentlichungstag der Anmeldung: **30.07.2025**
(21) Anmeldenummer: 24154464.2
(22) Anmeldetag: 29.01.2024
(51) Int. Cl.: H03K 17/95

(54) **INDUKTIVER NÄHERUNGSSENSOR, SENSORSYSTEM MIT INDUKTIVEN NÄHERUNGSSENSOREN SOWIE VERFAHREN ZUM BETREIBEN EINES SOLCHEN SENSORSYSTEMS**

(71) Anmelder: Pepperl+Fuchs SE, 68307 Mannheim (DE)
(72) Erfinder: Braunsmann, Christoph, 68307 Mannheim (DE); Höbel, Heiko, 68307 Mannheim (DE); Schaeuble, Caroline, 68307 Mannheim (DE)
(74) Vertreter: Banse & Steglich Patentanwälte PartmbB

(57) **Zusammenfassung**

Die Erfindung betrifft einen induktiver Näherungssensor (1) umfassend;
- eine Sensorspule (2),
- eine Pulsauswerteschaltung (3), die ausgebildet ist, um einen Anregeimpuls für die Sensorspule (2) bereitzustellen und eine resultierende Spannungsantwort zu erhalten;
- eine Steuereinheit (4), die ausgebildet ist, um
o entsprechend eines Pulsauswerteverfahrens die Pulsauswerteschaltung (3) so anzusteuern, dass die Sensorspule (2) mit einem Anregeimpuls vorbestimmter Zeitdauer angeregt wird;
o zumindest eine erste Messspannung zu einem bestimmten ersten Zeitpunkt nach Bereitstellen des Anregeimpulses zu erfassen, und
o eine Angabe zu einem Vorhandensein oder Nicht-Vorhandensein eines zu detektierenden Objekts (10) in einem Erfassungsbereich um die Sensorspule (2) bereitzustellen,

wobei eine Synchronisationseinheit (7) vorgesehen ist, um ein Synchronisationssignal zu empfangen, das angibt, ob oder wann ein Pulsauswerteverfahren in einem benachbarten Näherungssensor aktiv ist, und dass die Steuereinheit (4) ausgebildet ist, das Pulsauswerteverfahren abhängig von dem Synchronisationssignal zu starten.

## Beschreibung

### Technisches Gebiet

Die Erfindung betrifft induktive Näherungssensoren zum Messen eines Vorhandenseins eines zu detektierenden leitfähigen Objekts in einem Erfassungsbereich mithilfe eines Pulsauswerteverfahrens und Maßnahmen zur Vermeidung von Messfehlern bei zwei nahe zueinander benachbarten induktiven Näherungssensoren aufgrund eines Übersprechens eines Anregungsstromimpulses zwischen Sensorspulen.

### Technischer Hintergrund

Induktive Näherungssensoren können das Vorhandensein oder Nichtvorhandensein eines zu detektierenden leitfähigen Objekts mithilfe eines Pulsauswerteverfahrens ermitteln. Dabei wird in eine Sensorspule ein Stromimpuls eingeprägt und die Spannungsantwort ausgewertet. Der Verlauf der Spannungsantwort hängt von der Nähe des zu detektierenden leitfähigen Objekts in der Nähe der Sensorspule ab. Die Spannungsantwort variiert aufgrund der Induktion von Wirbelströmen in dem zu detektierenden Objekt, so dass eine Analyse des Verlaufs z. B. in Form einer Messung der Amplitude der Spannungsantwort nach einer vorbestimmten Zeitdauer nach dem Abfall des Spulenstroms auf 0 A eine Detektion eines an die Sensorspule angenäherten zu detektierenden Objekts ermöglicht.

Derartige induktive Näherungssensoren, die auf dem Prinzip der Pulsauswertung basieren, sind beispielsweise in den Druckschriften EP0492029B1 und EP4030623A1 bekannt.

In manchen Anwendungen kann es notwendig sein, mehrere baugleiche induktive Näherungssensoren in unmittelbarer Nähe zueinander zu betreiben. Dies kann beispielsweise zur Messung von Objektgeschwindigkeiten, Erfassung von mehreren Objekten auf begrenztem Raum oder zum Erreichen einer Messredundanz vorgesehen werden. Sind die Sensorspulen der Näherungssensoren nahe beieinander angeordnet, so besteht eine magnetische Kopplung mit einem nicht vernachlässigbaren Kopplungsfaktor zwischen den Sensorspulen. Dadurch kann ein durch eine der Sensorspulen bewirktes, sich zeitlich änderndes Magnetfeld Störspannungen in der Sensorspule eines anderen der Näherungssensoren induzieren, die sich in Form eines Störsignals bei der Auswertung einer Spannungsantwort in der Sensorspule des anderen Näherungssensors auswirkt und damit dessen Signalauswertung deutlich stören kann.

Im Falle von mehreren benachbarten induktiven Näherungssensoren mit Pulsauswertung bestimmt der momentane zeitliche Versatz der zyklischen Stromimpulse sowie die Art der Pulsauswertung der Spannungsantwort darüber, ob sich die beiden Pulsauswertungen der Näherungssensoren gegenseitig stören bzw. beeinflussen oder nicht. Da die Periodendauer der zyklischen Stromimpulse zwischen den Näherungssensoren leicht voneinander abweicht, da die Taktquellen der Steuereinheiten in den Näherungssensoren Streuungen unterliegen, ändert sich auch die Phasenlage der zyklischen Stromimpulse und moduliert in Stärke und Wirkrichtung der gegenseitigen Beeinflussung typischerweise mit der Differenz der Frequenzen der zyklischen Stromimpulse. Somit kann durch die Vorgabe einer Phasenlage nicht ohne Weiteres ausgeschlossen werden, dass die Pulsauswertung für einen induktiven Näherungssensor nicht durch den Betrieb des benachbarten Näherungssensors gestört wird.

Aus der Druckschrift DE 10 2011 018 430 A1 ist ein induktiver Näherungsschalter mit einem Schaltkreis, durch den eine Spule mit einer Spannungsquelle elektrisch verbunden ist und in dem ein Kondensator vorgesehen ist, durch den eine Induktions-Spannung erfasst ist, und mit einer Auswerteeinrichtung bekannt, durch die ein Schaltsignal bei Überschreiten einer Schwellwertspannung des Kondensators erzeugt ist, wobei durch die Auswerteeinrichtung die Spannungsversorgung der Spule in Abhängigkeit von zeitlich gemessenen Induktions-Spannungen des Kondensators verschoben ist und dass die Auswerteeinrichtung diese Spannung unmittelbar vor der Zuschaltung der Spule an die Spannungsquelle mit Hilfe der an dem Kondensator gemessenen Spannung erfasst.

Kurz vor dem Start eines neuen Pulses erfasst jeder Sensor die Pulsspannung mit Hilfe eines Kondensators. Liegt die Kondensatorspannung über einem gewissen Schwellwert, wird eine vorliegende Störung durch einen benachbarten Sensor vermutet. Um dieser Störung zeitlich auszuweichen, wird der Start des nachfolgenden Pulses um eine Zeitdauer verzögert. Dadurch wird gewährleistet, dass die Sensoren sich zeitlich versetzt mit einer Phasenlage synchronisieren, die unkritisch ist, d. h. dass die Sensoren können sich nach einer oder einigen wenigen Perioden nicht mehr gegenseitig stören. Der schnellere der beiden Sensoren passt seine Pulsperiode dabei im Mittel an die Periode des langsamen Sensors an.

Nachteilig bei einer derartigen induktiven Selbstsynchronisation ist, dass für eine Erkennung des benachbarten Näherungssensors eine minimale Kopplung nicht unterschritten und damit ein gewisser Mindestabstand nicht überschritten werden darf. Wird der Mindestabstand überschritten bzw. die induktive Kopplung kurzzeitig durch Annäherung eines zu detektierenden Objekts verringert, kann die Synchronisierung der Näherungssensoren verloren gehen, so dass sich zwei benachbarte Näherungssensoren unter Umständen dennoch gegenseitig beeinflussen können. Eine zuverlässige Synchronisation kann dadurch nicht gewährleistet werden.

Eine weitere Möglichkeit besteht darin, die Phasenlage zwischen den zyklischen Stromimpulsen der mehreren Näherungssensoren für jede Pulsperiode deutlich zu ändern, so dass sich für jede Messung deutlich unterscheidende Störeinflüsse festgestellt werden können. Mithilfe von geeigneten digitalen Filtern können kurzzeitige Schwankungen der Spannungsantwort bei bestimmten Phasenlagen als Ausreißer herausgefiltert werden, so dass Messwerte mit hohem Störanteil eliminiert werden können.

Ein solches Verfahren hat jedoch den Nachteil, dass durch die Filterung die mittlere Messrate der Näherungssensoren reduziert wird und diese darüber hinaus durch das sporadische Eliminieren einzelner Messwerte fluktuiert.

Druckschrift EP 3531557 A1 offenbart einen Näherungssensor zum Erfassen eines Erfassungsobjekts unter Verwendung eines Magnetfelds, umfassend eine Detektionsspule zum Erzeugen des Magnetfelds, eine Erregerschaltung zum wiederholten Zuführen eines gepulsten Erregerstroms an die Erfassungsspule, eine Erfassungsschaltung zum Erfassen des Erfassungsobjekts auf der Grundlage einer Spannung, die an beiden Enden der Erfassungsspule während einer vorbestimmten Zeitspanne erzeugt wird, nachdem die Zufuhr des Erregungsstroms unterbrochen ist, und eine Steuerschaltung zum Steuern der Erregungsschaltung, so dass ein Zeitpunkt des Abschaltens der Zufuhr des Erregungsstroms zu der Erfassungsspule aperiodisch wird.

Es ist Aufgabe der vorliegenden Erfindung, einen induktiven Näherungssensor zur Verfügung zu stellen, bei dem in einem Sensorsystem mit mehreren Näherungssensoren Störungen der Pulsauswertung durch den Betrieb benachbarter induktive Näherungssensoren vermieden werden können und die Messrate nicht beeinträchtigt wird.

### Offenbarung der Erfindung

Diese Aufgabe wird durch den induktiven Näherungssensor gemäß Anspruch 1, das Sensorsystem mit mehreren induktiven Näherungssensoren und das Verfahren zum Betreiben eines Sensorsystems gemäß den nebengeordneten Ansprüchen gelöst.

Weitere Ausgestaltungen sind in den abhängigen Ansprüchen angegeben.

Gemäß einem ersten Aspekt ist ein induktiver Näherungssensor vorgesehen, umfassend;
- eine Sensorspule,
- eine Pulsauswerteschaltung, die ausgebildet ist, um einen Anregeimpuls für die Sensorspule bereitzustellen und eine resultierende Spannungsantwort zu erhalten;
- eine Steuereinheit, die ausgebildet ist, um
   o entsprechend eines Pulsauswerteverfahrens die Pulsauswerteschaltung so anzusteuern, dass die Sensorspule mit einem Anregeimpuls vorbestimmter Zeitdauer angeregt wird;
   ∘ zumindest eine erste Messspannung zu einem bestimmten ersten Zeitpunkt nach dem Bereitstellen des Anregeimpulses zu erfassen und
   o eine Angabe zu einem Vorhandensein oder Nicht-Vorhandensein eines zu detektierenden Objekts in einem Erfassungsbereich um die Sensorspule bereitzustellen,
   wobei eine Synchronisationseinheit vorgesehen ist, um ein Synchronisationssignal zu empfangen, das angibt, ob oder wann ein Pulsauswerteverfahren in einem benachbarten Näherungssensor aktiv ist, und dass die Steuereinheit ausgebildet ist, das Pulsauswerteverfahren abhängig von dem Synchronisationssignal zu starten.

Weiterhin kann die Steuereinheit ausgebildet sein, das Pulsauswerteverfahren nur dann zu starten, wenn kein Pulsauswerteverfahren in einem benachbarten Näherungssensor aktiv ist.

Die Synchronisationseinheit kann ausgebildet sein, um gesteuert durch die Steuereinheit den Zeitpunkt und die Dauer des aktiven Pulsauswerteverfahrens zu signalisieren.

Gemäß einer Ausführungsform kann das Erfassen der ersten Messspannung zu einem bestimmten ersten Zeitpunkt nach dem Erreichen eines Spulenstroms von 0 A oder nach der fallenden Flanke des Anregeimpulses durchgeführt werden. Der Anregeimpuls kann einem Strom- oder Spannungs-Rechteckimpuls vorbestimmter zeitlicher Dauer entsprechen.

Gemäß einer Ausführungsform kann die Steuereinheit ausgebildet sein, um, wenn erkannt wird, dass in einem benachbarten Näherungssensor das Pulsauswerteverfahren aktiv ist, das Pulsauswerteverfahren dann gestartet wird, wenn das Pulsauswerteverfahren in dem benachbarten Näherungssensor beendet ist.

Weiterhin kann die Steuereinheit ausgebildet sein, um eine Spannungsdifferenz zwischen der ersten Messspannung und einer zweiten Messspannung zu ermitteln und diese als Angabe zu dem Vorhandensein oder Nicht-Vorhandensein eines zu detektierenden Objekts in einem Erfassungsbereich der Sensorspule bereitzustellen, wobei die Steuereinheit ausgebildet ist, um die zweite Messspannung zu einem bestimmten zweiten Zeitpunkt nach dem Bereitstellen des Anregeimpulses, z.B. nach dem Erreichen eines Spulenstroms von 0 A oder nach der fallenden Flanke des Anregeimpulses, nach dem ersten Zeitpunkt zu erfassen.

Der Betrieb eines induktiven Näherungssensors wird in der Regel durch eine Steuereinheit, die beispielsweise einen Mikrocontroller umfassen kann, gesteuert. In der Regel wird dazu periodisch ein Stromimpuls in eine Sensorspule eingeprägt und nach dem Abschalten des Spulenstroms die resultierende Spannungsantwort ausgewertet. Das Auswerten der Spannungsantwort erfolgt durch Messen einer ersten Messspannung einer resultierenden Spannungsantwort zu einem Zeitpunkt nach dem Bereitstellen des Anregeimpulses, wie z.B. unmittelbar oder kurz nach der fallenden Flanke des Stromimpulses oder nach Erreichen eines Spulenstroms von 0A, und optional einer zweiten Messspannung nach einer vorgegebenen längeren Zeitdauer nach dem Bereitstellen des Anregeimpulses, wie z.B. nach der fallenden Flanke des Stromimpulses oder nach Erreichen eines Spulenstroms von 0A, um einen Referenzwert zu erhalten, auf den sich die erste Messspannung bezieht. Die Spannungsdifferenz aus den beiden Messspannungen ergibt dann eine repräsentative Größe der Spannungsantwort, mit der mithilfe eines Schwellwertvergleichs auf das Vorhandensein oder Nichtvorhandensein eines zu detektierenden Objekts geschlossen werden kann.

Die Bestromung der Sensorspule mit dem Stromimpuls bewirkt ein sich änderndes Magnetfeld im Umfeld der Sensorspule. Sind mehrere Sensorspulen in unmittelbarer Nähe zueinander angeordnet, so dass ein Stromimpuls in einer Sensorspule einen Spannungsimpuls in einer benachbarten Sensorspule bewirkt, so können die Auswertungen der Spannungsantworten beeinträchtigt werden. Um eine gegenseitige Beeinflussung der Auswertung einer Spannungsantwort mithilfe des Pulsauswerteverfahrens von mehreren einander benachbarten induktiven Näherungssensoren zu vermeiden, ist es notwendig, während der Spannungsmessung zum Erhalten der Messspannungen sicherzustellen, dass kein Störeinfluss aufgrund des Anlegens eines Stromimpulses an eine Sensorspule eines benachbarten induktiven Näherungssensors auftritt.

Tritt während einer der Spannungsmessungen eine Störung in einem benachbarten induktiven Näherungssensor aufgrund einer Flanke eines Stromimpulses durch eine Sensorspule auf, so wird die Spannungsmessung verfälscht. Um zu gewährleisten, dass die Messung der Spannung für die Spannungsantwort ohne Störeinflüsse erfolgen kann, werden die Betriebe der induktiven Näherungsschalter des Sensorsystems zueinander synchronisiert.

Zur Übertragung des Synchronisationssignals kann eine elektrische Synchronisationsleitung vorgesehen sein. Dabei kann das Synchronisationssignal durch einen ersten Spannungspegel angeben, dass kein Pulsauswerteverfahren aktiv ist und durch einen zweiten Spannungspegel angeben, dass ein Pulsauswerteverfahren aktiv ist.

Um den Betrieb von zwei oder mehr als zwei induktiven Näherungssensoren entsprechend aufeinander abzustimmen, können diese über eine Synchronisationsleitung miteinander verbunden sein. Auf der Synchronisationsleitung wird durch einen Näherungssensor ein Synchronisationssignal angelegt, das angibt, wenn gerade ein Pulsauswerteverfahren aktiv ist oder eine Pulsauswertung durch das Pulsauswerteverfahren in dem betreffenden Näherungssensor erfolgt. Wird von einem Näherungssensor durch eine Synchronisationsschaltung erkannt, dass eine Pulsauswertung in einem anderen Näherungssensor gerade aktiv ist oder stattfindet, so wird der Start eines anstehenden Pulsauswerteverfahren, das mit der Generierung des Stromimpulses durch die Sensorspule beginnt, verzögert. Dadurch wird der Messzyklus des betreffenden Näherungssensors gestoppt, bis das Synchronisationssignal angibt, dass gerade kein Pulsauswerteverfahren aktiv ist.

Das Synchronisationssignal kann definiert sein, dass mit einem ersten Spannungspegel signalisiert wird, dass gerade kein Pulsauswerteverfahren aktiv ist, und dass mit einem zweiten Spannungspegel signalisiert wird, dass ein Pulsauswerteverfahren gerade aktiv ist. Das Anlegen des ersten Spannungspegels kann somit nach der Auswertung der Spannungsantwort signalisieren, dass eine Messung mit einem weiteren induktiven Näherungssensor erfolgen kann. Das Pulsauswerteverfahren ist während des Anlegens des Stromimpulses und für eine vorgegebene Zeitdauer nach dem Bereitstellen des Anregeimpulses aktiv. Innerhalb der vorgegebenen Zeitdauer werden zumindest die erste Messspannung und ggfs. die zweite Messspannung gemessen.

Die Synchronisationsleitung ist dazu mit allen sich nahe beieinander befindlichen Näherungssensoren verbunden kann mithilfe des Spannungspegels angeben, ob ein Pulsauswerteverfahren gestartet werden kann oder nicht. Dazu ist in jedem der Näherungssensoren eine Synchronisationseinheit vorgesehen, die bei aktivem Pulsauswerteverfahren den zweiten Spannungspegel auf der Synchronisationsleitung durch einen entsprechenden Pull-up oder Pull-down-Widerstand bereitstellt oder bei nicht aktivem Pulsauswerteverfahren den Spannungspegel auf der Synchronisationsleitung als ein Eingangssignal für die Steuereinheit des betreffenden Näherungssensors detektiert.

Insbesondere wird so mithilfe eines Synchronisierungsverfahrens angegeben, wenn ein Pulsauswerteverfahren in einem der Näherungssensoren aktiv ist, und damit bei den übrigen Näherungssensoren des Sensorsystems die Ausführung des Pulsauswerteverfahrens blockiert.

Die Steuereinheit des Näherungssensors sieht im Normalbetrieb eine periodische oder zyklische Bereitstellung des Stromimpulses für das Pulsauswerteverfahren vor. Vor dem Anlegen des Stromimpulses wird überprüft, ob der Spannungspegel auf der Synchronisationsleitung angibt, dass kein Pulsauswerteverfahren aktiv ist (bei dem ersten Spannungspegel). Ist dies der Fall, führt die Steuereinheit das Pulsauswerteverfahren durch und legt den Spannungspegel auf der Synchronisationsleitung so ein, dass angegeben wird, dass ein Pulsauswerteverfahren aktiv ist (zweiter Spannungspegel). Wird dagegen vor Starten des Pulsauswerteverfahrens ein zweiter Spannungspegel auf der Synchronisationsleitung detektiert, der angibt, dass ein Pulsauswerteverfahren aktiv ist, so wird das anstehende Pulsauswerteverfahren verzögert und gewartet, bis der Spannungspegel auf der Synchronisationsleitung angibt, dass kein Pulsauswerteverfahren stattfindet (durch Änderung zu dem ersten Spannungspegel). Dazu kann in der Steuereinheit der Spannungspegel auf der Synchronisationsleitung regelmäßig, insbesondere periodisch, abgefragt werden oder durch zeitweises Verlängern oder Verkürzen der Pulsperiode des zyklisch durchgeführten Pulsauswerteverfahren das angeforderte Pulsauswerteverfahren dann verzögert und nicht überlappend zu dem zuvor stattfindenden Pulsauswerteverfahren ausgeführt werden.

Weiterhin kann vorgesehen sein, dass die Steuereinheit ausgebildet ist, um, wenn das Synchronisationssignal für mehr als eine vorbestimmte Zeitdauer angibt, dass ein Pulsauswerteverfahren in einem benachbarten Näherungssensor aktiv ist, das Pulsauswerteverfahren zu starten.

Insbesondere kann so die Steuereinheit feststellen, dass über die Synchronisationsleitung während einer vorbestimmten Zeitdauer signalisiert wird, dass ein Pulsauswerteverfahren aktiv ist, und bei Überschreiten der Zeitdauer kann das Pulsauswerteverfahren ungeachtet des Spannungspegels auf der Synchronisationsleitung gestartet werden, um zu vermeiden, dass die Messzyklen für einen Näherungssensor dauerhaft deaktiviert sind und keine Messungen mehr vorgenommen werden können.

Weiterhin kann die Steuereinheit ausgebildet sein, um den Spannungspegel des Synchronisationssignals auf den zweiten Spannungspegel zu legen, wenn oder bevor der Anregeimpuls angelegt wird und/oder um den Spannungspegel des Synchronisationssignals auf den ersten Spannungspegel zu legen, nachdem zumindest die erste Messpannung oder ggfs. auch die zweite Messspannung erfasst worden ist.

Das Synchronisationssignal kann bei einem zyklischen Betrieb der Pulsauswerteverfahren einen Takt vorgeben. An diesem Takt können sich dann die Starts der Pulsauswerteverfahren orientieren, wobei jeder der Näherungssensoren das Pulsauswerteverfahren mit einer jeweils individuellen Phasenlage zu dem Taktsignal startet. Die Synchronisationsleitung kann dann genutzt werden, um bei einem Starten des Sensorsystems den Näherungssensoren die Zyklusfrequenz und die individuellen Phasenlagen zuzuordnen.

Gemäß einem weiteren Aspekt ist ein Sensorsystem mit mehreren der obigen Näherungssensoren vorgesehen, wobei die Näherungssensoren über eine Synchronisationsleitung miteinander verbunden sind.

Gemäß einem weiteren Aspekt ist ein Verfahren zum Betreiben eines induktiven Näherungssensors mit einer Sensorspule vorgesehen; mit folgenden Schritten:
- Bereitstellen eines Anregeimpulses zum Beaufschlagen der Sensorspule mit einer vorbestimmten Zeitdauer entsprechend eines Pulsauswerteverfahrens;
- Messen mindestens einer Messspannung innerhalb einer Spannungsantwort nach dem Bereitstellen des Anregeimpulses zu erfassen;
- Bereitstellen einer Angabe zu einem Vorhandensein oder Nicht-Vorhandensein eines zu detektierenden Objekts in einem Erfassungsbereich der Sensorspule;
wobei der Zustand von benachbarten Näherungssensoren empfangen wird, der angibt, ob oder wann dort ein Pulsauswerteverfahren aktiv ist, und dass das Pulsauswerteverfahren nur dann gestartet wird, wenn kein Pulsauswerteverfahren in einem benachbarten Näherungssensor aktiv ist.

### Kurzbeschreibung der Zeichnungen

Ausführungsformen werden nachfolgend anhand der beigefügten Zeichnungen näher erläutert. Es zeigen:
- Figur 1: eine schematische Darstellung eines induktiven Näherungssensors mit einer Synchronisationseinheit;
- Figur 2: Signalzeitdiagramme der Pulssteuerspannung, des Schaltsignals, des Spulenstroms, der Spulenspannung und der Spannung am Analog-Digital-Wandler;
- Figur 3: ein Flussdiagramm zur Veranschaulichung eines Verfahrens, wie es in einer Steuereinheit eines Näherungssensors ausgeführt wird; und
- Figur 4: Signalzeitdiagramme des Synchronisationsleitungspotenzials, der Spulenströme von zwei Näherungssensoren und der beiden Analog-Digital-Wandlerspannungen der Näherungssensoren; und
- Figur 5: eine schematische Darstellung eines induktiven Näherungssensors mit einer Synchronisationseinheit, bei der eine Messung der zweiten Messspannung entstört ist.

### Beschreibung von Ausführungsformen

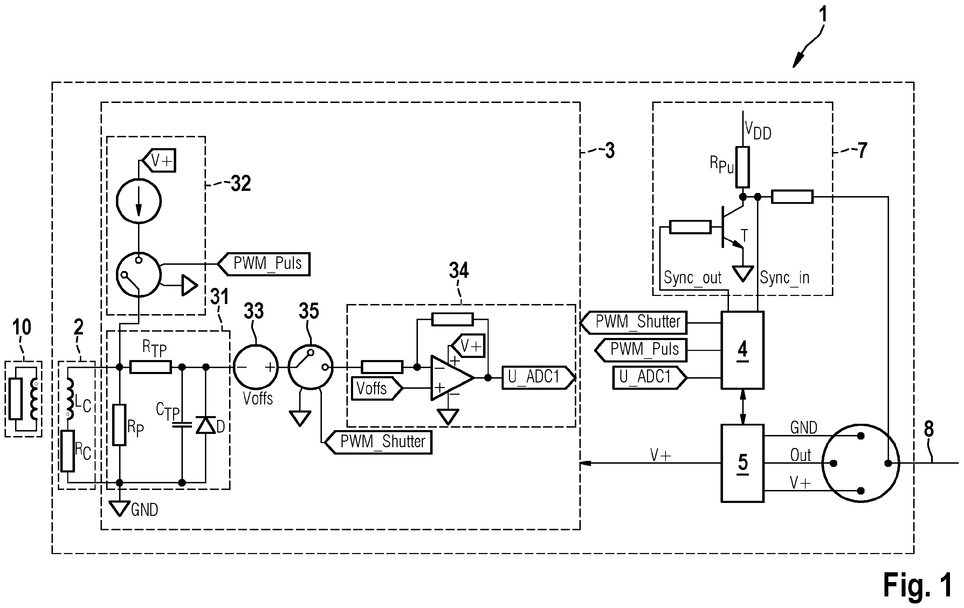

In Figur 1 ist eine schematische Darstellung eines induktiven Näherungssensors 1 gemäß einer Ausführungsform der Erfindung dargestellt.

Der Näherungssensor 1 umfasst eine Sensorspule 2 mit einer Induktivität Lc und einem parasitären Widerstand R_{c}, die elektrisch mit einer Pulsauswerteschaltung 3 verbunden ist. Die Pulsauswerteschaltung 3 weist ein passives Netzwerk 31 auf, das parallel zu der Sensorspule 2 geschaltet ist.

Die Sensorspule 2 ist seriell mit einer schaltbaren Stromquelle 32 verbunden, um gesteuert durch ein Pulssteuersignal PWM_Puls von einer Steuereinheit 4 zyklisch einen Stromimpuls an die Sensorspule 2 anzulegen.

Das passive Netzwerk 31 umfasst einen Entladewiderstand Rp, einen RC-Tiefpass R_{TP}, C_{TP} und eine Diode D. Kurz nach Ausschalten der Stromquelle 32 ist die Spannungsantwort zunächst vom Selbstinduktionspuls der Spule dominiert. Das passive Netzwerk 31 dient dazu, um den Selbstinduktionsimpuls zum Schutz der nachfolgenden Schaltungskomponenten in seiner Höhe zu begrenzen.

Die Sensorspule 2 dient als Sonde für den Näherungssensor 1 und generiert ein Magnetfeld. Gemäß einem Pulsauswerteverfahren werden Stromimpulse in die Sensorspule 2 eingeprägt, so dass die Spannungsantwort der durch die Selbstinduktion und die Leitfähigkeit und Permeabilität des zu detektierenden Objekts 10 bestimmten induzierten Spannung von dem Vorhandensein oder Nichtvorhandensein des zu detektierenden Objekts 10 im Erfassungsbereich abhängt.

Weiterhin kann eine Offset-Spannungsquelle 33 der Pulsauswerteschaltung 3 mit der Sensorspule 2 verbunden sein, um die resultierende Spannungsantwort mit einem Spannungs-Offset V_{offs} zu beaufschlagen, um die Spannungsantwort in einen geeigneten Spannungsmessbereich zu bringen.

Mithilfe einer Verstärkerschaltung 34, die einen Operationsverstärker 341 aufweisen kann, können Messspannungen U_ADC1 der Spannungsantwort zu bestimmten Zeitpunkten verstärkt und mit einem Analog-Digital-Wandler in der Steuereinheit 4 gemessen werden. Die Steuereinheit 4 kann dazu einen Mikrocontroller aufweisen, in den ein AD-Wandler integriert ist, um die Messspannung digitalisiert bereitzustellen.

Um eine Sättigung des Operationsverstärkers der Verstärkerschaltung 34 und eine damit einhergehende undefiniert lange Erholungszeit zu vermeiden, kann die Spannungsantwort der Sensorspule 2 mithilfe eines Analogschalters 35 zeitweise vom Verstärkereingang abgetrennt werden. Wird der Analogschalter 35 mit Beginn des Stromimpulses geöffnet und erst einige Zeit, z. B. zwischen 10 und 50 µs, nach Abschalten des Spulenstroms wieder geschlossen, ist der Selbstinduktionsimpuls, d. h. das Spannungsniveau der Spannungsantwort, so weit abgeklungen, dass eine Verstärkersättigung ausgeschlossen ist. Der Analogschalter 35 wird ebenfalls durch die Steuereinheit 4 mithilfe eines entsprechenden Schaltsignals PWM_Shutter gesteuert.

Die Auswertung der Spannungsantwort erfolgt ebenfalls gesteuert durch die Steuereinheit 4 durch Messen von zwei Messspannungen mit einem vorgegebenen zeitlichen Abstand.

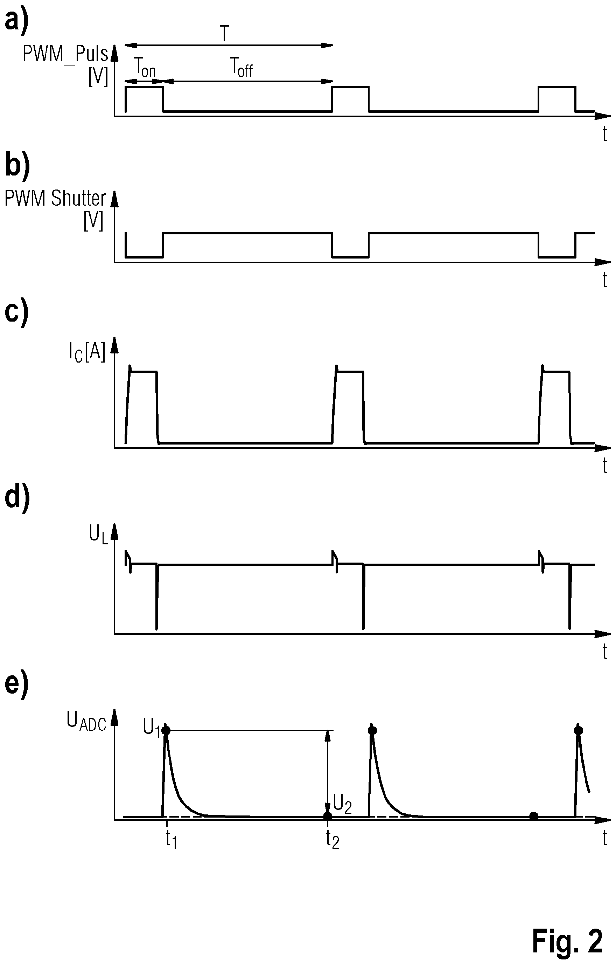

Figur 2 zeigt schematisch Signal-Zeit-Diagramme zur Veranschaulichung einer Durchführung des Pulsauswerteverfahrens. Man erkennt, dass das Stromimpulssignal des Spulenstroms Ic, das durch die Steuereinheit 4 mithilfe des Strompulssignals PWM_Puls bereitgestellt wird, das Anlegen eines Stromimpulses an der Sensorspule 2 bewirkt. Der Stromimpuls ist in Fig. 2c dargestellt. Durch die fallende Flanke des Stromimpulses Ic, d. h. der Strom sinkt auf 0 A, erfolgt eine Induktion einer Spannung in der Sensorspule, die sich über das passive Netzwerk 31 langsam abbaut.

Um eine Überspannung für nachfolgende Schaltungsteile zu vermeiden, wird der Analogschalter mithilfe des Schaltsignals PWM_Shutter (Fig. 2b) so gesteuert, dass dieses den Analogschalter 35 erst nach einer kurzen Zeitdauer nach dem Erreichen von 0 A oder nach der fallenden Flanke des Stromimpulses einschaltet und so die Spannungsantwort der Sensorspule 2 erst dann an die Verstärkerschaltung 34 anlegt, wenn diese bereits teilweise abgeklungen ist. Die Spannungsantwort ist in dem Verlauf der Figur 2e dargestellt.

Die Spannungsmessungen der Messspannungen erfolgen zu festgelegten Zeitpunkten t1 und t2, die ausgehend von dem Zeitpunkt der fallenden Flanke des Strompulssignals PWM_Puls definiert sein können. Die Spannungsdifferenz zwischen den Messspannungen ermöglicht so eine Messung einer Angabe über die Gegeninduktivität des zu detektierenden Objekts, die auf die Sensorspule 2 wirkt, und die von dem Vorhandensein oder Nichtvorhandensein des zu detektierenden Objekts 10 abhängt.

Die erste Messspannung U1 zum Zeitpunkt t1 entspricht etwa der Höhe der Spannungsantwort des Spannungsimpulses, und die zweite Messspannung U2 zum Zeitpunkt t2 entspricht einer Referenz-Spannung, die als Referenz bzw. Bezugsspannung für die zuerst gemessene erste Messspannung dient.

Die Spannungsdifferenz kann als Ausgangssignal über eine geeignete Schnittstelle 6 bereitgestellt werden. Alternativ kann das Ergebnis eines Schwellwertvergleichs dieser Spannungsdifferenz mit einem vorgegebenen Schwellwert vorgenommen und das Ergebnis des Schwellwertvergleichs über die Schnittstelle 5 bereitgestellt werden. Das Ergebnis des Schwellwertvergleichs entspricht dann einer Angabe über das Vorhandensein oder Nichtvorhandensein eines zu detektierenden Objekts 10.

Um den Betrieb des Näherungssensors 1 mit dem Betrieb eines benachbart angeordneten Näherungssensors 1 zu synchronisieren, insbesondere um Störeinflüsse bei der Messung mit dem Pulsauswerteverfahren auszuschließen, ist eine Synchronisationseinheit 7 vorgesehen. Die Synchronisationseinheit 7 steht über eine Synchronisationsleitung 8 mit einem oder mehreren Näherungssensoren 1 in Verbindung. Die Synchronisationsleitung 8 verbindet so mehrere Näherungssensoren 1 miteinander, die jeweils mit einer Synchronisationseinheit ausgestattet sind.

Die Synchronisationseinheit 7 umfasst einen Pull-up-Widerstand R_{PU}, um ein erstes Spannungspotenzial VDD auf die Synchronisationsleitung 8 einzuprägen. Die Synchronisationsleitung 8 ist ggfs. über einen Schutzwiderstand mit einem Synchronisationseingang Sync_In mit der Steuereinheit 4 verbunden.

Die Synchronisationseinheit 7 des jeweiligen Näherungssensors 1 steht mit der Steuereinheit 4 in Verbindung und kann gesteuert durch einen Synchronisationsausgang Sync_Out mithilfe eines Transistors T, über den die Synchronisationsleitung 8 mit einem niedrigeren zweiten Spannungspotenzial GND verbunden ist, ein zweites Spannungspotenzial auf die Synchronisationsleitung 8 eingeprägt werden. Die Synchronisationseinheit 7 umfasst somit einen Treiber, um gesteuert durch ein Synchronisationssignal an dem Synchronisationsausgang Sync_Out einen zweiten Spannungspegel auf die Synchronisationsleitung 8 anzulegen. Wird der Transistor T geschlossen, so liegt das zweite Spannungspotenzial auf der Synchronisationsleitung an. Wird dieser geöffnet, so zieht der Pull-up-Widerstand RPU den Spannungspegel der Synchronisationsleitung 8 auf das erste Spannungspotenzial.

Der Spannungspegel auf der Synchronisationsleitung 8 kann über den Synchronisationseingang Sync_In von der Steuereinheit 4 erfasst werden, um das Durchführen des Pulsauswerteverfahrens entsprechend zu steuern.

Die Synchronisationsleitung 8 der Näherungssensoren kann auch jeweils an eine übergeordnete Steuerung angeschlossen werden. In diesem Fall kann die Steuerung die Pulsauswerteverfahren der Näherungssensoren durch Wahl geeigneter Spannungspegel der Synchronisationsleitung 8 gezielt starten und stoppen und dadurch einen ungestörten Betrieb benachbarter Näherungssensoren ermöglichen. Dazu kann die Steuerung zum einen das Synchronisationssignal auswerten, um festzustellen, welcher der Näherungssensoren gerade ein Pulsauswerteverfahren aktiv durchführt. Dies kann z.B. durch Kodierung über die Höhe des zweiten Spannungspegels erfolgen. Zum anderen kann die Steuerung den Start eines Pulsauswerteverfahren aktiv blockieren, indem diese einen zweiten Spannungspegel auf der Synchronisationsleitung 8 bewirkt.

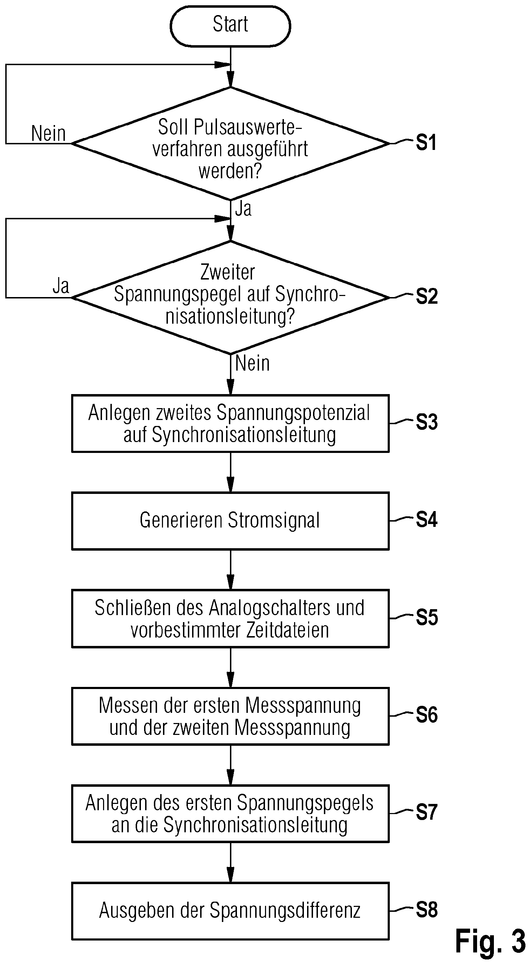

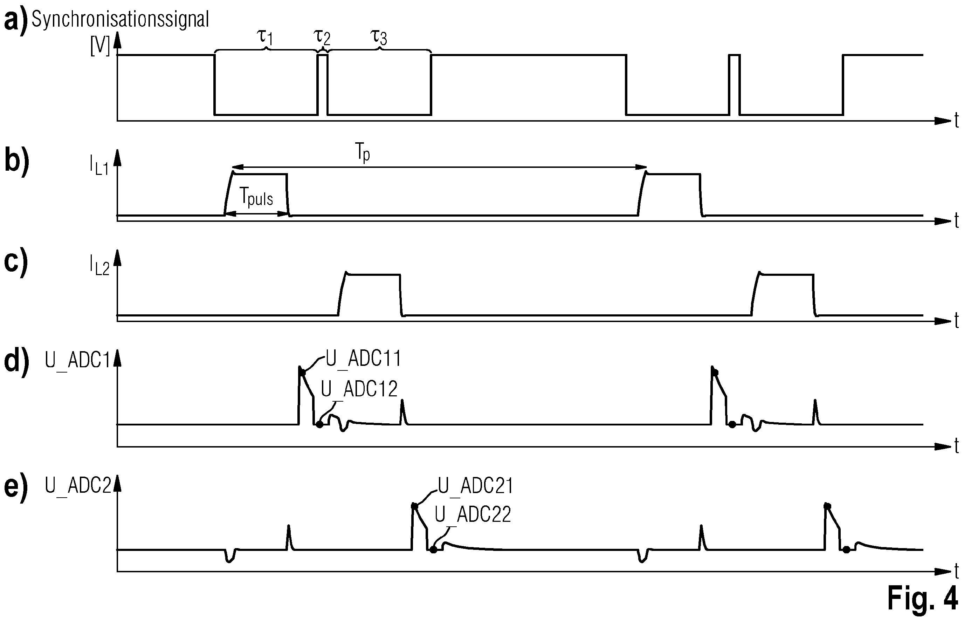

In Figur 3 ist ein Flussdiagramm zur Veranschaulichung eines Verfahrens zum Betreiben eines Sensorsystems mit mehreren induktiven Näherungssensoren 1 dargestellt. Das Verfahren wird weiterhin anhand der Signal-Zeit-Diagramme der Figur 4 erläutert. Der Ablauf wird durch die Steuereinheiten 4 der Näherungssensoren 1 gesteuert und erfolgt in der Regel periodisch gemäß einer vorgegebenen Zyklusfrequenz des Betreibens des Pulsauswerteverfahrens in jeder der Steuereinheiten 4. Die Pulsauswerteverfahren werden dabei zeitversetzt ohne Überscheidung ausgeführt. Das Verfahren startet mit einem geöffneten Analogschalter 35.

Gesteuert durch einen Systemtakt wird in Schritt S1 überprüft, ob ein Pulsauswerteverfahren aktiv durchgeführt werden soll. Ist dies der Fall (Alternative: Ja), wird das Verfahren mit Schritt S2 fortgesetzt. Andernfalls (Alternative: Nein) wird zu Schritt S1 zurückgesprungen.

In Schritt S2 wird zunächst der Spannungspegel der Spannung auf der Synchronisationsleitung 8 abgefragt und überprüft, welcher Spannungspegel anliegt. Wird in Schritt S2 festgestellt, dass der zweite Spannungspegel anliegt, der angibt, dass ein Pulsauswerteverfahren bei einem weiteren der Näherungssensoren 1 noch aktiv ist (Alternative: Ja), so wird zu Schritt S2 zurückgesprungen und damit gewartet, bis der Spannungspegel auf der Synchronisationsleitung 8 wieder auf den ersten Spannungspegel ansteigt. Wird festgestellt, dass der erste Spannungspegel erreicht ist und dass damit kein weiteres Pulsauswerteverfahren aktiv ist (Alternative. Nein), wird das Verfahren mit Schritt S3 fortgesetzt.

In Schritt S3 wird der Synchronisationsausgang Sync_Out der Steuereinheit 4 aktiviert und dadurch der Transistor T geschlossen und damit das Spannungspotenzial auf der Synchronisationsleitung 8 auf den zweiten Spannungspegel gesenkt. Dies signalisiert den übrigen Näherungssensoren 1 an der Synchronisationsleitung 8, dass keine Messungen mit dem Pulsauswerteverfahren stattfinden dürfen.

Gleichzeitig oder kurz (z.B. zwischen 1 -100 µs) danach wird in Schritt S4 mit dem Anlegen des Strompulssignals PWM_Puls zum Anlegen des Strompulses das Pulsauswerteverfahren gestartet und das Strompulssignal PWM_Puls für eine vorbestimmte Zeitdauer generiert, das über die geschaltete Stromquelle 32 einen Stromimpuls an die Sensorspule 2 anlegt. Dies ist für die Näherungssensoren 1 in den Diagrammen der Figur 4b und 4c gezeigt. Der Strompuls hat eine vordefinierte Dauer T_{Puls}, die deutlich geringer, d. h. kleiner als 20 % oder kleiner als 10% der Periodendauer T_{P} der zyklischen Pulsauswerteverfahren sein kann.

Ist die Dauer des Stromimpulses verstrichen, d. h. es liegt z.B. eine fallende Flanke des Spulenstroms vor oder der Spulenstrom hat 0 A erreicht, so wird in Schritt S5 nach einer kurzen ersten Zeitdauer von beispielsweise zwischen 10 und 50 µs der zuvor geöffnete Analogschalter 35 mithilfe des Schaltsignals PWM_Shutter geschlossen, um so eine bereits etwas abgeklungene Spannung der Spannungsantwort an die Verstärkerschaltung 34 anzulegen.

Nach einer vorbestimmten zweiten Zeitdauer zum Zeitpunkt t1 nach dem Erreichen von 0 Ampere nach Anlegen des Stromimpulses wird in Schritt S6 eine erste Messspannung U_ADC11 gemessen und zu einem späteren Zeitpunkt t2, der durch eine vorbestimmte dritte Zeitdauer nach dem Erreichen von 0 Ampere nach dem Stromimpuls definiert ist, eine zweite Messspannung U_ADC12 gemessen. Die Messung erfolgt mit dem Analog-Digital-Wandler der Steuereinheit 4. Analog ergeben sich für den weiteren Näherungssensor eine erste und eine zweite Messspannung U_ADC21, U_ADC22.

In Schritt S7 wird unmittelbar nach der Messung der zweiten Messspannung U_ADC2 die Synchronisationsleitung 8 wieder freigegeben und der Synchronisationsausgang Sync_Out der Steuereinheit 4 deaktiviert. Dadurch wird der Transistor T geöffnet und damit das Spannungspotenzial auf der Synchronisationsleitung 8 auf den ersten Spannungspegel angehoben. Das Pulsauswerteverfahren ist dann beendet und es kann von dem weiteren Näherungssensor an der Synchronisationsleitung 8 ein Pulsauswerteverfahren durchgeführt werden.

In Schritt S8 kann die Spannungsdifferenz zwischen der ersten und der zweiten Messspannung als Ausgangssignal dienen oder zur Generierung des Ausgangssignals wie oben beschrieben verwendet werden. Insbesondere kann dadurch (Schwellenwertvergleich mit Differenzspannung) eine Angabe zu einem Vorhandensein oder Nicht-Vorhandensein eines zu detektierenden Objekts 10 in einem Erfassungsbereich der Sensorspule 2 bereitgestellt werden.

Die Anzahl von Näherungssensoren in dem Sensorsystem kann auch mehr als zwei betragen, wobei jedoch die Summe der Dauern der Pulsauswerteverfahren aller Näherungssensoren kleiner sein muss als die gesamte Periodendauer T_{P} der einzelnen Näherungssensoren.

Wird in Schritt S2 festgestellt, dass auf der Synchronisationsleitung 8 der zweite Spannungspegel für mehr als eine vorgegebene Zeitdauer, wie beispielsweise zwei Periodendauern T_{P}, anliegt, so kann die Messung ungeachtet des Spannungspegels auf der Synchronisationsleitung 8 gestartet werden. Dies schließt den Fall aus, dass aufgrund eines Fehlers der Spannungspegel der Synchronisationsleitung 8 auf dem zweiten Spannungspegel verharrt.

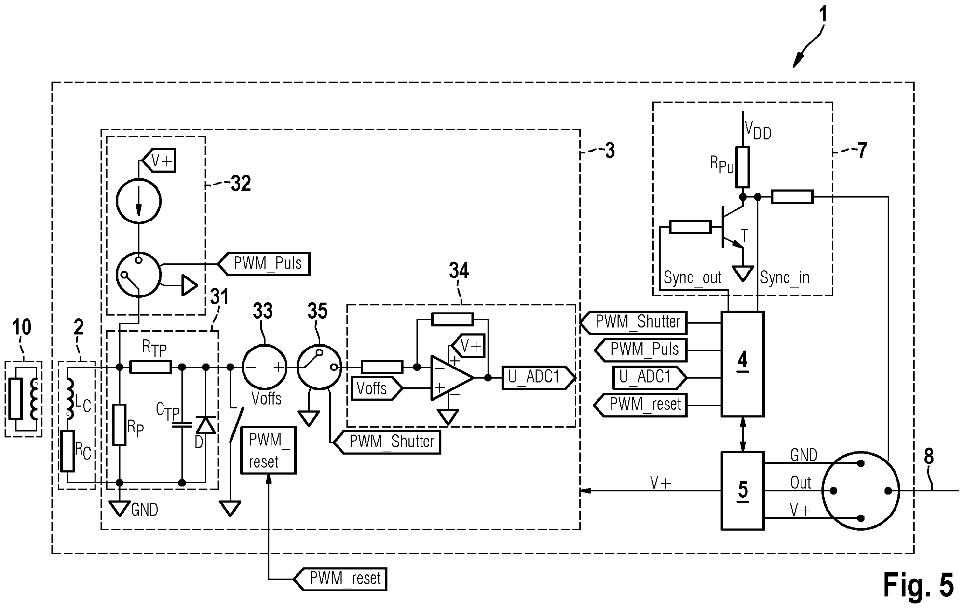

Figur 5 zeigt eine schematische Darstellung eines induktiven Näherungssensors mit einer Synchronisationseinheit 7, bei der eine Messung der zweiten Messspannung entstört ist. Dazu wird ein Kurzschlussschalter 36 vorgesehen, der parallel zu dem passiven Netzwerk 31 angeordnet ist und gesteuert durch ein Rücksetzsignal PWM_reset der Steuereinheit 4 den Spannungsabfall über dem Netzwerk 31 kurzschließt. Da der Widerstand R_{P} in der Regel deutlich kleiner als R_{TP} gewählt wird, hat das Schließen des Kurzschlussschalters 36 keinen Einfluss auf die Energie der Sensorspule 2. Das Kurzschließen des Netzwerks 31 dient dazu, das Signal der Sensorspule 2 auszublenden, um die Offset-Spannung der Offset-Spannungsquelle 33 und eine etwaige zusätzliche Offset-Spannung der Verstärkerschaltung unbeeinflusst von der Spannung der Sensorspule messen zu können. Somit kann die zweite Messspannung, welche der Spannung der Offset-Spannungsquelle 33 zuzüglich einer etwaigen Offsetspannung der nachfolgenden Schaltungsteile 34 und 35 entsprechen soll, jederzeit ohne Beeinflussung einer eingekoppelten Störung (z.B. durch das störende Feld eines Nachbarsensors) gemessen werden.

Die Ermittlung der Spannungsdifferenz kann somit nur noch bei einem, nämlich dem ersten Zeitpunkt *t*₁ verfälscht werden. Dies halbiert effektiv die Störwahrscheinlichkeit und erlaubt zudem deutlich flexiblere und kürzere Pulsauswertungsverfahren, da für eine Pulsoffsetbestimmung anhand der zweiten Messspannung nicht zwangsläufig das Ende der Spannungsantwort abgewartet werden muss. Der Spannungspegel auf der Synchronisationsleitung 8 kann daher auch schon unmittelbar nach der Messung der ersten Messspannung auf den ersten Spannungspegel gesetzt werden, so dass andere Näherungssensoren des Sensorsystems das Pulsauswerteverfahren starten dürfen.

Das Synchronisationssignal hat den Zweck, in einfacher Weise zu signalisieren, wenn ein Pulsauswerteverfahren in einer der an die Synchronisationsleitung angeschlossenen Näherungssensoren aktiv ist. Das Signalisieren kann neben Spannungspegeln auch durch das Anlegen oder Übermitteln von PWM-Signalen, von Schwingungssignalen oder von digitalen Signalen, die die Information über den Zeitpunkt des Starts des Pulsauswerteverfahrens, die Dauer des Pulsauswerteverfahrens und/oder eine Identifikation des Näherungssensors, in dem das Pulsauswerteverfahren gerade aktiv ist, erfolgen. Hierdurch können z.B. vordefinierte Messreihenfolgen realisiert werden, insbesondere wenn mehr als zwei Sensoren an die Synchronisationsleitung angeschlossenen sind, was z.B. bei der präzisen Auswertung von Objektgeschwindigkeiten vorteilhaft ist.

Auch eine Messung mit unterschiedlich hohen Messraten in den mehreren Näherungssensoren kann dadurch realisiert werden, um unterschiedlichen Anforderungen in der Messapplikation zu genügen.

Weiterhin könnte das Synchronisationssignal auch mehr als zwei Spannungspegel aufweisen, um unterschiedliche Phasen des Pulsauswerteverfahren unterscheiden zu können, z.B. die Phase, in der der Spulenstrom steigt, die Phase, in der der Spulenstrom konstant (ungleich Null) ist, die Phase, in der der Spulenstrom sinkt, und die Phase, in der Messwerte erfasst werden. Dies ermöglicht z.B. die Synchronisation mit einer Phasenlage, bei welcher ein erster Näherungssensor Messwerte erfasst während der Spulenstrom des zweiten benachbarten Näherungssensors konstant aber ungleich Null ist und somit ebenfalls keine Störspannung in der Sensorspule des ersten Näherungssensors induziert wird. Dadurch kann die maximale Anzahl an Näherungssensoren, die bei einer gegebenen Pulsperiode über die Synchronisationsleitung synchronisiert werden können, erhöht werden.

## Patentansprüche

1. Induktiver Näherungssensor (1) umfassend;
- eine Sensorspule (2),
- eine Pulsauswerteschaltung (3), die ausgebildet ist, um einen Anregeimpuls für die Sensorspule (2) bereitzustellen und eine resultierende Spannungsantwort zu erhalten;
- eine Steuereinheit (4), die ausgebildet ist, um
∘ entsprechend eines Pulsauswerteverfahrens die Pulsauswerteschaltung (3) so anzusteuern, dass die Sensorspule (2) mit einem Anregeimpuls vorbestimmter Zeitdauer angeregt wird;
∘ zumindest eine erste Messspannung (U_ADC11, U_ADC12) zu einem bestimmten ersten Zeitpunkt nach Bereitstellen des Anregeimpulses zu erfassen, und
∘ eine Angabe zu einem Vorhandensein oder Nicht-Vorhandensein eines zu detektierenden Objekts (10) in einem Erfassungsbereich um die Sensorspule (2) abhängig von der ersten Messspannung (U_ADC11, U_ADC12) bereitzustellen,
**dadurch gekennzeichnet, dass**
eine Synchronisationseinheit (7) vorgesehen ist, um ein Synchronisationssignal zu empfangen, das angibt, ob oder wann ein Pulsauswerteverfahren in einem benachbarten Näherungssensor aktiv ist, und dass die Steuereinheit (4) ausgebildet ist, das Pulsauswerteverfahren abhängig von dem Synchronisationssignal zu starten.

2. Induktiver Näherungssensor (1) nach Anspruch 1, wobei die Steuereinheit (4) ausgebildet ist, das Pulsauswerteverfahren nur dann zu starten, wenn kein Pulsauswerteverfahren in einem benachbarten Näherungssensor aktiv ist.

3. Induktiver Näherungssensor (1) nach Anspruch 1 oder 2, wobei die Synchronisationseinheit (7) ausgebildet ist, um gesteuert durch die Steuereinheit (4) den Zeitpunkt und die Dauer des aktiven Pulsauswerteverfahrens zu signalisieren.

4. Induktiver Näherungssensor (1) nach einem der Ansprüche 1 bis 3, wobei die Steuereinheit (4) ausgebildet ist, um, wenn erkannt wird, dass in einem benachbarten Näherungssensor das Pulsauswerteverfahren aktiv ist, das Pulsauswerteverfahren dann gestartet wird, wenn das Pulsauswerteverfahren in dem benachbarten Näherungssensor beendet ist.

5. Induktiver Näherungssensor (1) nach einem der Ansprüche 1 bis 5, wobei eine elektrische Synchronisationsleitung (8) vorgesehen ist, um das Synchronisationssignal zu übertragen.

6. Induktiver Näherungssensor (1) nach einem der Ansprüche 1 bis 5, wobei das Synchronisationssignal durch einen ersten Spannungspegel angibt, dass kein Pulsauswerteverfahren aktiv ist und durch einen zweiten Spannungspegel angibt, dass ein Pulsauswerteverfahren aktiv ist.

7. Induktiver Näherungssensor (1) nach Anspruch 6, wobei die Steuereinheit (4) ausgebildet ist, um den Spannungspegel des Synchronisationssignals auf den zweiten Spannungspegel zu legen, wenn oder bevor der Anregeimpuls bereitgestellt wird und/oder um den Spannungspegel des Synchronisationssignals auf den ersten Spannungspegel zu legen, nachdem zumindest die erste Messpannung (U_ADC11, U_ADC12) erfasst worden ist.

8. Induktiver Näherungssensor (1) nach einem der Ansprüche 1 bis 7, wobei die Steuereinheit (4) ausgebildet ist, um, wenn das Synchronisationssignal für mehr als eine vorbestimmte Zeitdauer angibt, dass ein Pulsauswerteverfahren in einem benachbarten Näherungssensor (1) aktiv ist, das Pulsauswerteverfahren zu starten.

9. Induktiver Näherungssensor (1) nach einem der Ansprüche 1 bis 8, wobei die Steuereinheit (4) ausgebildet ist, um eine Spannungsdifferenz zwischen der ersten Messspannung (U_ADC11, U_ADC12) und einer zweiten Messspannung (U_ADC21, U_ADC22) zu ermitteln und diese als Angabe zu dem Vorhandensein oder Nicht-Vorhandensein eines zu detektierenden Objekts (10) in einem Erfassungsbereich der Sensorspule (2) bereitzustellen, wobei die Steuereinheit (4) ausgebildet ist, um die zweite Messspannung (U_ADC21, U_ADC22) zu einem bestimmten zweiten Zeitpunkt nach dem Bereitstellen des Anregeimpulses nach dem ersten Zeitpunkt zu erfassen.

10. Induktiver Näherungssensor (1) nach Anspruch 9, wobei ein Kurzschlussschalter (36) vorgesehen ist, um zum Zeitpunkt der Messung der zweiten Messspannung (U_ADC21, U_ADC22) diese als eine Referenzspannung vorzugeben.

11. Sensorsystem mit mehreren Näherungssensoren (1) nach einem der Ansprüche 1 bis 10, wobei die Näherungssensoren (1) über eine Synchronisationsleitung (8) miteinander verbunden sind.

12. Verfahren zum Betreiben eines induktiven Näherungssensors (1) mit einer Sensorspule (2); mit folgenden Schritten:
- Bereitstellen (S4) eines Anregeimpulses zum Beaufschlagen der Sensorspule (2) mit einer vorbestimmten Zeitdauer entsprechend eines Pulsauswerteverfahrens;
- Messen (S6) mindestens einer Messspannung (U_ADC11, U_ADC12) innerhalb einer Spannungsantwort nach Bereitstellen des Anregeimpulses zu erfassen;
- Bereitstellen einer Angabe zu einem Vorhandensein oder Nicht-Vorhandensein eines zu detektierenden Objekts (10) in einem Erfassungsbereich der Sensorspule (2) abhängig von der mindestens einen Messspannung (U_ADC11, U_ADC12);
**dadurch gekennzeichnet, dass**
der Zustand von benachbarten Näherungssensoren empfangen wird, der angibt, ob oder wann dort ein Pulsauswerteverfahren aktiv ist, und dass das Pulsauswerteverfahren nur dann gestartet wird (S2), wenn kein Pulsauswerteverfahren in einem benachbarten Näherungssensor aktiv ist.

## Geänderte Patentansprüche

### Geänderte Patentansprüche gemäss Regel 137(2) EPÜ.

1. Induktiver Näherungssensor (1) umfassend;
- eine Sensorspule (2),
- eine Pulsauswerteschaltung (3), die ausgebildet ist, um einen Anregeimpuls für die Sensorspule (2) bereitzustellen und eine resultierende Spannungsantwort zu erhalten;
- eine Steuereinheit (4), die ausgebildet ist, um
∘ entsprechend eines Pulsauswerteverfahrens die Pulsauswerteschaltung (3) so anzusteuern, dass die Sensorspule (2) mit einem Anregeimpuls vorbestimmter Zeitdauer angeregt wird;
∘ zumindest eine erste Messspannung (U_ADC11, U_ADC12) zu einem bestimmten ersten Zeitpunkt nach Bereitstellen des Anregeimpulses zu erfassen, und
∘ eine Angabe zu einem Vorhandensein oder Nicht-Vorhandensein eines zu detektierenden Objekts (10) in einem Erfassungsbereich um die Sensorspule (2) abhängig von der ersten Messspannung (U_ADC11, U_ADC12) bereitzustellen,
wobei eine Synchronisationseinheit (7) vorgesehen ist, um ein Synchronisationssignal zu empfangen, das angibt, ob oder wann ein Pulsauswerteverfahren in einem benachbarten Näherungssensor aktiv ist, und dass die Steuereinheit (4) ausgebildet ist, das Pulsauswerteverfahren abhängig von dem Synchronisationssignal zu starten,
**dadurch gekennzeichnet, dass** die Steuereinheit (4) ausgebildet ist, um, wenn erkannt wird, dass in einem benachbarten Näherungssensor das Pulsauswerteverfahren aktiv ist, das Pulsauswerteverfahren nur dann zu starten, wenn das Pulsauswerteverfahren in dem benachbarten Näherungssensor beendet ist, wobei eine elektrische Synchronisationsleitung (8) vorgesehen ist, um das Synchronisationssignal zwischen den Näherungssensoren zu übertragen.

2. Induktiver Näherungssensor (1) nach Anspruch 1, wobei die Synchronisationseinheit (7) ausgebildet ist, um gesteuert durch die Steuereinheit (4) den Zeitpunkt und die Dauer des aktiven Pulsauswerteverfahrens zu signalisieren.

3. Induktiver Näherungssensor (1) nach einem der Ansprüche 1 bis 2, wobei das Synchronisationssignal durch einen ersten Spannungspegel angibt, dass kein Pulsauswerteverfahren aktiv ist und durch einen zweiten Spannungspegel angibt, dass ein Pulsauswerteverfahren aktiv ist.

4. Induktiver Näherungssensor (1) nach Anspruch 3, wobei die Steuereinheit (4) ausgebildet ist, um den Spannungspegel des Synchronisationssignals auf den zweiten Spannungspegel zu legen, wenn oder bevor der Anregeimpuls bereitgestellt wird und/oder um den Spannungspegel des Synchronisationssignals auf den ersten Spannungspegel zu legen, nachdem zumindest die erste Messpannung (U_ADC11, U_ADC12) erfasst worden ist.

5. Induktiver Näherungssensor (1) nach einem der Ansprüche 1 bis 4, wobei die Steuereinheit (4) ausgebildet ist, um, wenn das Synchronisationssignal für mehr als eine vorbestimmte Zeitdauer angibt, dass ein Pulsauswerteverfahren in einem benachbarten Näherungssensor (1) aktiv ist, das Pulsauswerteverfahren zu starten.

6. Induktiver Näherungssensor (1) nach einem der Ansprüche 1 bis 5, wobei die Steuereinheit (4) ausgebildet ist, um eine Spannungsdifferenz zwischen der ersten Messspannung (U_ADC11, U_ADC12) und einer zweiten Messspannung (U_ADC21, U_ADC22) zu ermitteln und diese als Angabe zu dem Vorhandensein oder Nicht-Vorhandensein eines zu detektierenden Objekts (10) in einem Erfassungsbereich der Sensorspule (2) bereitzustellen, wobei die Steuereinheit (4) ausgebildet ist, um die zweite Messspannung (U_ADC21, U_ADC22) zu einem bestimmten zweiten Zeitpunkt nach dem Bereitstellen des Anregeimpulses nach dem ersten Zeitpunkt zu erfassen.

7. Induktiver Näherungssensor (1) nach Anspruch 6, wobei ein Kurzschlussschalter (36) vorgesehen ist, um zum Zeitpunkt der Messung der zweiten Messspannung (U_ADC21, U_ADC22) diese als eine Referenzspannung vorzugeben.

8. Sensorsystem mit mehreren Näherungssensoren (1) nach einem der Ansprüche 1 bis 7, wobei die Näherungssensoren (1) über eine Synchronisationsleitung (8) miteinander verbunden sind.

9. Verfahren zum Betreiben eines induktiven Näherungssensors (1) mit einer Sensorspule (2); mit folgenden Schritten:
- Bereitstellen (S4) eines Anregeimpulses zum Beaufschlagen der Sensorspule (2) mit einer vorbestimmten Zeitdauer entsprechend eines Pulsauswerteverfahrens;
- Messen (S6) mindestens einer Messspannung (U_ADC11, U_ADC12) innerhalb einer Spannungsantwort nach Bereitstellen des Anregeimpulses zu erfassen;
- Bereitstellen einer Angabe zu einem Vorhandensein oder Nicht-Vorhandensein eines zu detektierenden Objekts (10) in einem Erfassungsbereich der Sensorspule (2) abhängig von der mindestens einen Messspannung (U_ADC11, U_ADC12);
**dadurch gekennzeichnet, dass**
der Zustand von benachbarten Näherungssensoren über eine elektrische Synchronisationsleitung (8) empfangen wird, der angibt, ob oder wann dort ein Pulsauswerteverfahren aktiv ist, und dass das Pulsauswerteverfahren nur dann gestartet wird (S2), wenn kein Pulsauswerteverfahren in einem benachbarten Näherungssensor aktiv ist, wobei, wenn erkannt wird, dass in einem benachbarten Näherungssensor das Pulsauswerteverfahren aktiv ist, das Pulsauswerteverfahren nur dann gestartet wird, wenn das Pulsauswerteverfahren in dem benachbarten Näherungssensor beendet ist.
